# EUROPÄISCHE PATENTANMELDUNG

(11) **EP 4 328 959 A1**
(43) Veröffentlichungstag der Anmeldung: **28.02.2024**
(21) Anmeldenummer: 22191907.9
(22) Anmeldetag: 24.08.2022
(51) Int. Cl.: H01L 21/48, H01L 23/373, H05K 7/20, F28D 15/04

(54) **KÜHLKÖRPER FÜR EIN ELEKTRONIKBAUTEIL AUFWEISEND EINEN GEPRESSTEN METALLSCHAUM**

(71) Anmelder: Siemens Aktiengesellschaft, 80333 München (DE)
(72) Erfinder: Boschert, Stefan, 85579 Neubiberg (DE); Schwarz, Markus, 80798 München (DE); Stegmeier, Stefan, 81825 München (DE); Walbrecker-Baar, Christian, 85757 Karlsfeld (DE); Beckert, Thomas, 90461 Nürnberg (DE); Nannen, Hauke, 90443 Nürnberg (DE)
(74) Vertreter: Siemens Patent Attorneys

(57) **Zusammenfassung**

Die Erfindung betrifft einen Kühlkörper (10) für ein Elektronikbauteil,
aufweisend einen Metallschaum, der Metallschaum aufweisend:
- Mindestens einen ersten Bereich (1), aufweisend eine erste Dichte, und
- mindestens einen zweiten Bereich (2), aufweisend mindestens eine zweite Dichte, wobei die mindestens eine zweite Dichte höher als die erste Dichte ist, wobei der zweite Bereich (2) als gepresster Metallschaum ausgebildet ist.

Außerdem betrifft die Erfindung eine Herstellung eines Kühlkörpers (10) für ein Elektronikbauteil.

## Beschreibung

### HINTERGRUND DER ERFINDUNG

### Gebiet der Erfindung

Die vorliegende Erfindung betrifft einen Kühlkörper für ein Elektronikbauteil. Die Erfindung betrifft außerdem eine zugehörige Herstellung eines Kühlkörpers für ein Elektronikbauteil.

### Beschreibung des Stands der Technik

Die Lebensdauer und Zuverlässigkeit von elektronischen Bauteilen ist im Wesentlichen von deren Wärmemanagement abhängig. Aufgrund der Miniaturisierung und der damit steigenden Verlustleistungsdichte gewinnt das thermische Management elektronischer Bauteile mehr und mehr an Bedeutung.

Module mit elektronischen Halbleiterbauelementen, insbesondere Leistungshalbleiter, reagieren bekanntermaßen sehr empfindlich auf zu hohe Betriebstemperaturen. Eine Temperaturkontrolle der Elektronikbausteine ist zwingend erforderlich, um Fehlfunktionen der Bauteile oder einer gesamten Baugruppe, im Worst-Case-Szenario einen thermisch verursachten Totalschaden, zu vermeiden.

Etliche Entwärmungsaufgaben werden durch bekannten Strangkühlkörper aus Aluminium gelöst. Strangkühlkörper, auch als Extrusionskühlkörper bezeichnet, sind in der Praxis die am häufigsten eingesetzte Methode zur Bauteilentwärmung und basieren auf dem Wirkprinzip der freien Konvektion.

Steigen allerdings die abzuführenden Verlustleistungen, so steigen gleichfalls die geometrischen Abmessungen sowie das Gewicht des notwendigen Kühlkörpers. Ab einem gewissen Punkt, welcher durch die thermischen Randbedingungen hervorgerufen wird, treten allerdings die Strangkühlkörper und das damit verbundene Wirkprinzip an die Leistungsgrenze des machbaren. In diesem Fall können Kühlkörper mit einem Lüftermotor versehen werden, was die Wärmeableitleistung je nach Luftgeschwindigkeit und Luftvolumen steigern kann, letztendlich aber nur ein Behelf darstellt.

Auch additive Methoden, wie insbesondere selektives Laserschmelzen (SLM), werden verwendet, um maßgeschneiderte Kühler aufzubauen. Speziell die graduelle Verteilung der Wärme und die Anpassung an die Applikation ist hier von Vorteil. Jedoch ergeben sich aufgrund der hohen Pulverkosten und der langsamen Herstellmethode deutliche Limitierungen hinsichtlich einer Massenanwendung.

Neuere Kühlkonzepte benutzen offenporigen Schaum als Kühlkörper. Aufgrund der großen Oberfläche ist dieser prädestiniert für Kühlaufgaben. Nachteile bieten aber die durch das Herstellungsverfahren vorhandenen Hohlräume in den Schaum-Stegen, was wiederrum eine geringere Wärmeleitfähigkeit bedingt. Ein weiterer Nachteil ist eine schlechte Einkopplung der Wärme an der Baseplate, auch als Basisplatte bezeichenbar. Dieser Effekt kann teilweise durch Variation der Porengröße reduziert werden. Zusätzlich findet nur ein geringer Transport der Wärme in die distalen Gegenden, in zur Baseplate weiter entfernten Gegenden, des Schaums statt.

Eine Kombination von Pin-Fin Kühlern und Metallschaum kann dies verbessern. Diese Kombination ist aber sehr teuer und mit hohem industriellem Aufwand verbunden.

Die Aufgabe der Erfindung besteht darin, eine Lösung für einen verbesserten Kühlkörper für Elektronikbauteile bereitzustellen.

### ZUSAMMENFASSUNG DER ERFINDUNG

Die Erfindung ergibt sich aus den Merkmalen der unabhängigen Ansprüche. Vorteilhafte Weiterbildungen und Ausgestaltungen sind Gegenstand der abhängigen Ansprüche. Ausgestaltungen, Anwendungsmöglichkeiten und Vorteile der Erfindung ergeben sich aus der nachfolgenden Beschreibung und den Zeichnungen.

Die Erfindung betrifft einen Kühlkörper für ein Elektronikbauteil,
aufweisend einen Metallschaum, der Metallschaum aufweisend:
- Mindestens einen ersten Bereich, aufweisend eine erste Dichte, und
- mindestens einen zweiten Bereich, aufweisend mindestens eine zweite Dichte, wobei die mindestens eine zweite Dichte höher als die erste Dichte ist, wobei der zweite Bereich als gepresster Metallschaum ausgebildet ist.

Damit ein effektiver Wärmetransport von Baseplate in den Schaum erfolgen kann, ist eine höhere Dichte von Vorteil. Diese höhere Dichte wird durch die mindestens eine zweite Dichte von dem mindestens einem zweiten Bereich aufgewiesen. Die mindestens eine zweite Dichte kann unterschiedliche Dichtewerte aufweisen, alle Werte der zweiten Dichte sind höher als die erste Dichte.

Vorzugsweise ist der mindestens eine zweite Bereich so angeordnet, dass er direkt mit einer Baseplate eines Elektronikbauteils in Kontakt treten kann, um dort Wärme aufzunehmen und eine Entwärmung über Weiterleitung der Wärme in distale Gegenden des Metallschaums herbeizuführen.

Ein elektronisches Bauteil gibt somit an die Baseplate Wärme ab. Die Baseplate gibt wiederum Wärme an den Metallschaum ab. Da der Schaum in dem mindestens einem zweiten Bereich eine höhere Dichte aufweist als an dem mindestens einen ersten Bereich, ist hier die Wärmeaufnahme in den Schaum höher als im mindestens einen ersten Bereich.

Die Erfindung bietet somit ein effizienten Weg zur Wärmeabfuhr und um dem Wärmeaufkommen eines Elektronikbauteils entgegenzuwirken.

Der mindestens eine zweite Bereich wird durch Pressen im Schaum eingebracht. Durch das Pressen und die dadurch entstehende Verdichtung kann die Wärme an Bereichen höherer Dichte effektiver in den Schaum eingebracht werden.

Das Pressen ist insbesondere als ein Stempeln und/oder ein Rollen ausgebildet. Dabei wird die mindestens eine zweite Dichte des mindestens einen zweiten Bereich in den Metallschaum eingedrückt.

In einer Weiterbildung der Erfindung ist die mindestens eine zweite Dichte als ein gradueller Dichteverlauf ausgebildet. Der graduelle Dichteverlauf ist auch als ein Gradient an Dichtewerten bezeichenbar. Bevorzugt sind die höheren Dichtewerte des graduellen Dichteverlaufs an der Baseplate angeordnet und niedrigere Dichtewerte des graduellen Dichteverlaufs in von der Baseplate entfernten Gegenden angeordnet. Der graduelle Dichteverlauf zeichnet sich somit durch eine höhere Wärmeleitung in dichteren Bereichen und dünnere Stege mit wenige Wärmeaufnahme in weniger dichten Bereichen aus.

In einer weiteren Weiterbildung der Erfindung weist der Kühlkörper außerdem eine Kontaktfläche auf, wobei die Kontaktfläche ausgebildet ist, mit einer Basisplatte des Elektronikbauteils in Kontakt zu treten. Nach einem Aufbringen auf eine Baseplate an der Kontaktfläche kann die Wärme durch die verdichteten Bereiche in den Schaum transportiert werden.

In einer weiteren Weiterbildung der Erfindung ist der mindestens eine zweite Bereich senkrecht zu der Kontaktfläche angeordnet. Somit wird eine Verdichtung, insbesondere der Gradientenverlauf, senkrecht zur Kontaktfläche, und insbesondere der Baseplate und daher Wärmequelle, eingebracht.

In einer weiteren Weiterbildung der Erfindung weist der gepresster Metallschaum:
- eine einseitige Verdichtung oder
- eine zweiseitige Verdichtung
auf.

Die einseitige Verdichtung ist durch ein einseitiges Pressen des Metallschaums herstellbar.

Die zweiseitige Verdichtung ich durch ein zweiseitiges Pressen des Metallschaums herstellbar.

In einer weiteren Weiterbildung der Erfindung ist der mindestens eine erste Bereich ausgebildet, von einem Kühlmedium, insbesondere Wasser und/oder Luft, durchströmt zu werden. Durch die nicht verdichteten Stellen, den mindestens einen ersten Bereich, kann somit weiterhin Kühlmedium fließen und zusätzlich Wärme aufnehmen.

In einer weiteren Weiterbildung der Erfindung weist der Kühlkörper außerdem auf:
mindestens einen dritten Bereich, wobei der mindestens eine dritte Bereich als ein Hohlraum ausgebildet ist.

Der Hohlraum ist auch als Aussparung bezeichenbar.

Für ein Herstellen des Hohlraums gestaltet sich eine Verarbeitung von Polymerschaum deutlich einfacher als bei dem Metallschaum. Vor einem Galvanikprozess wird insbesondere ein Vollmaterial in den Hohlraum eingelegt, welches durch den Galvanikprozess angebunden wird. Nach dem Galvanikprozess wird das Polymer ausgebrannt, während das Metall und damit ein Metallschaum bestehen bleibt.

Als Vollmaterial eignet sich besonders ein Material mit einer höherer Wärmeleitfähigkeit als der Metallschaum, insbesondere ein Metall.

Die Verdichtung in dem mindestens einem zweiten Bereich ist an den unterschiedlichen Produktionsschritten des Schaums herstellbar, insbesondere bereits im Kunststoff-Basisschaum vor dem Galvanikprozess oder in dem finalen Metallschaum nach dem Galvanikprozess.

Auch dieser Metallschaum kann nach der Galvanik durch Pressung verdichtet werden.

Insbesondere ist die eingebrachte Öffnung auch zur Verbesserung der Durchströmung nutzbar.

In einer weiteren Weiterbildung der Erfindung weist der Kühlkörper außerdem auf:
mindestens einen vierten Bereich, wobei der mindestens eine vierte Bereich:
   - ein Vollmaterial und/oder
   - ein Lotmaterial und/oder
   - ein Metallpulver und/oder
aufweist, wobei der mindestens eine vierte Bereich:
   - von dem mindestens einem zweiten Bereich umschlossen und/oder
   - in Kontakt mit dem mindestens einem zweiten Bereich angeordnet ist.

Das Vollmaterial wird in den mindestens einen zweiten Bereich insbesondere vor oder nach dem Verdichten eingeführt, was die Wärmeleitfähigkeit der verdichteten Bereiche weiter erhöht.

Eine zusätzliche Erhöhung der Wärmeleitfähigkeit wird durch das Einbringen von dem Lotmaterial erreicht. Kapillarkräfte ziehen flüssiges Lotmaterial/Lot in die Poren des Schaums und dadurch verschließt das Lot offene Bereiche des Schaums, wodurch eine weitere Verdichtung erreicht wird. Zuvor eingebrachtes Metallpulver, mit höherer Leitfähigkeit als das Lot, erhöht die Wärmeleitfähigkeit zusätzlich. Das Metallpulver wird durch das Lotmaterial fixiert.

Wobei der mindestens eine vierte Bereich von dem mindestens einem zweiten Bereich umschlossen ist, bedeutet, dass der mindestens eine vierte Bereich innerhalb des mindestens einem zweiten Bereichs angeordnet ist.

Wobei der mindestens eine vierte Bereich in Kontakt mit dem mindestens einem zweiten Bereich angeordnet ist, ist insbesondere durch ein vor dem Verpressen untergelegtes Metall herstellbar, wobei das Metall nach der Verdichtung, durch Kontaktschweißen, mit dem Schaum verbunden wird. Ein Vorteil dieser Variante ist die direkte Anbindung des Schaums an insbesondere die Baseplate.

In einer weiteren Weiterbildung der Erfindung ist das Vollmaterial als ein mit dem Metallschaum verschweißtes Metall ausgebildet, wobei das Vollmaterial ausgebildet ist, mit einer Baseplate des Elektronikbauteils in Kontakt zu treten.

In einer weiteren Weiterbildung der Erfindung ist der zweite Bereich ausgebildet, Wärme in den Metallschaum aufzunehmen.

Die Erfindung umfasst außerdem eine Herstellung eines Kühlkörpers für ein Elektronikbauteil,
mit den Schritten:
- Ein Bereitstellen eines Metallschaums, wobei der Metallschaum mindestens einen ersten Bereich, aufweisend eine erste Dichte, aufweist und
- Ein erstens Pressen des Metallschaums an mindestens einem zweiten Bereich,
   wodurch der Metallschaum an dem mindestens einem zweiten Bereich mindestens eine zweite Dichte erhält, wobei die mindestens eine zweite Dichte höher als die erste Dichte ist, und
   wodurch der Metallschaum an mindestens einem ersten Bereich die ersten Dichte behält.

In einer weiteren Weiterbildung der Erfindung wird für das erste Pressen:
- Ein Stempel und/oder
- eine Rolle
verwendet.

In einer weiteren Weiterbildung der Erfindung umfasst die Herstellung die weiteren Schritte:
- ein zweites Pressen des mindestens einem zweiten Bereichs von entgegengesetzter Seite des ersten Pressens und/oder
- ein Bereitstellen eines Vollmaterials vor dem ersten Pressen, wobei das Vollmaterial nach dem ersten Pressen innerhalb des mindestens einem zweiten Bereichs oder in Kontakt mit dem mindestens einem zweiten Bereich angeordnet ist und/oder
- ein Einbringen eines Lotmaterials in dem mindestens einen zweiten Bereich.

In einer weiteren Weiterbildung der Erfindung umfasst die Herstellung den weiteren Schritt:
- ein Verscheißen des Vollmaterials mit dem mindestens einem zweiten Bereich vor dem ersten Pressen.

Hierbei wird vor dem Verpressen ein Vollmaterial, insbesondere ein Metall untergelegt, welches nach der Verdichtung, durch Kontaktschweißen, mit dem Schaum verbunden wird. Ein Vorteil dieser Variante ist die direkte Anbindung des Schaums an insbesondere die Baseplate.

In einer weiteren Weiterbildung der Erfindung wird durch die erfindungsgemäße Herstellung ein erfindungsgemäßer Kühlkörper bereitgestellt.

Der vorgeschlagene Kühlkörper kombiniert die Vorteile der Strangkühlkörper, nämlich die gute thermische Anbindung und Wärmeverteilung im Kühlkörper, mit den Vorteilen der Schäume, nämlich der großen Oberfläche und der erhöhten Erzeugung von Turbulenzen. Im Gegensatz zu den Schäumen aus dem Stand der Technik welche aufwendig mit variierender Porengröße hergestellt werden, kann durch die vorliegende Erfindung aus einem standardisierten Ausgangsmaterial - einem offenporigen Schaum - die für die jeweilige Anwendung individuell besten Wärmeverteilstrukturen eingebracht werden.

Die Verwendung eines Metallschaums ist insbesondere von Vorteil, da getrieben durch andere Industriethemen, insbesondere der Batterietechnik, Leichtbau u.a., sinken die Herstellkosten für Metallschäume rasant.

### KURZE BESCHREIBUNG DER ZEICHNUNGEN

Die Besonderheiten und Vorteile der Erfindung werden aus den nachfolgenden Erläuterungen mehrerer Ausführungsbeispiele anhand der schematischen Zeichnungen ersichtlich.

Es zeigen
- Fig. 1: eine schematische Darstellung eines Kühlkörpers auf einer Baseplate,
- Fig. 2: eine schematische Darstellung eines Kühlkörpers vor und nach Herstellung eines gepressten Bereichs mit graduellem Dichteverlauf,
- Fig. 3: eine schematische Darstellung eines Kühlkörpers mit einseitiger Verdichtung,
- Fig. 4: eine schematische Darstellung eines Kühlkörpers mit zweiseitiger Verdichtung und einem Vollmaterial,
- Fig. 5: eine schematische Darstellung eines Kühlkörpers mit einem Hohlraum, insbesondere für ein Vollmaterial,
- Fig. 6: eine schematische Darstellung eines Kühlkörpers mit zweiseitiger Verdichtung und einem Hohlraum, insbesondere für eine Durchströmung,
- Fig. 7: eine schematische Darstellung eines Kühlkörpers mit einseitiger Verdichtung und einem untergelegten Vollmaterial, insbesondere einem untergelegten und angeschweißten Metall, in Ansicht von oben,
- Fig. 8: eine schematische Darstellung eines Kühlkörpers mit einem untergelegten Vollmaterial, insbesondere einem untergelegten und angeschweißten Metall, in Seitenansicht,
- Fig. 9: eine schematische Darstellung und eines Kühlkörpers mit einseitiger Verdichtung, einem Lotmaterial und einem Metallpulver, und
- Fig. 10: ein Ablaufdiagramm des erfindungsgemäßen Verfahrens zur Herstellung eines Kühlkörpers.

### DETAILLIERTE BESCHREIBUNG DER ERFINDUNG

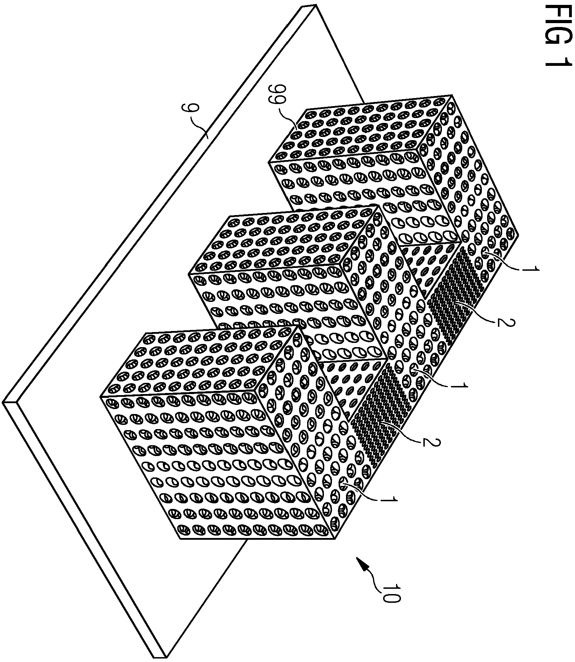

Fig. 1 zeigt eine schematische Darstellung eines Kühlkörpers 10 für ein Elektronikbauteil auf einer Baseplate 9. Der Kühlkörper 10 weist einen Metallschaum auf. Der Metallschaum weist auf:
- Mindestens einen ersten Bereich 1, aufweisend eine erste Dichte, und
- mindestens einen zweiten Bereich 2, aufweisend mindestens eine zweite Dichte, wobei die mindestens eine zweite Dichte höher als die erste Dichte ist, wobei der zweite Bereich 2 als gepresster Metallschaum ausgebildet ist.

Der Kühlkörper 10 weist außerdem eine Kontaktfläche 99 auf, wobei die Kontaktfläche 99 ausgebildet ist, mit der Basisplatte 9 des Elektronikbauteils in Kontakt zu treten.

Der mindestens eine zweite Bereich 2 ist senkrecht zu der Kontaktfläche 99 angeordnet.

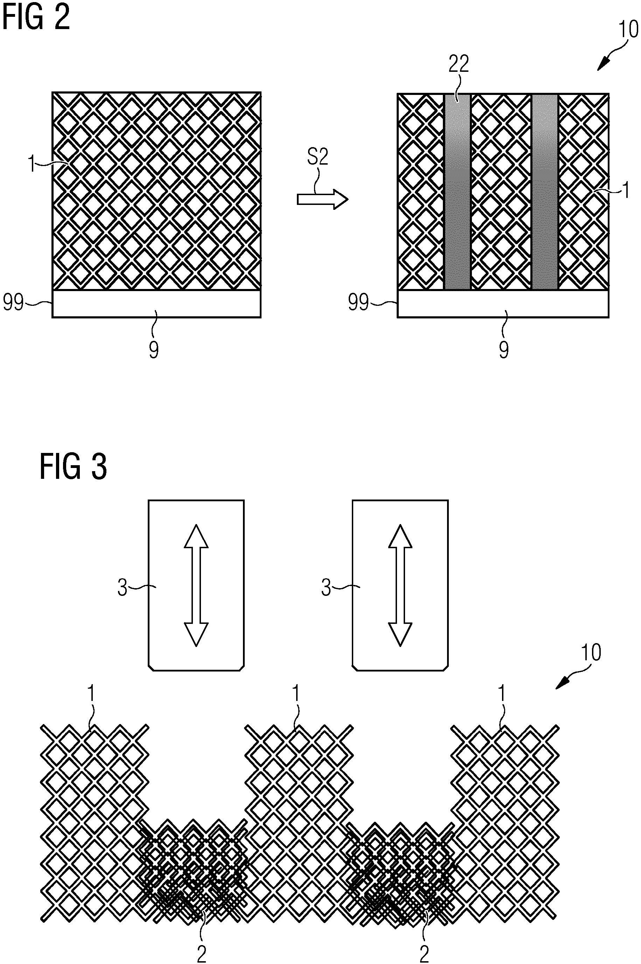

Fig. 2 zeigt eine schematische Darstellung eines Kühlkörpers 10 auf einer Baseplate 9 vor und nach Herstellung eines gepressten Bereichs mit graduellem Dichteverlauf durch ein Pressen S2.

In einer Weiterbildung der Erfindung ist die mindestens eine zweite Dichte des zweiten Bereichs 2 als ein gradueller Dichteverlauf 22 ausgebildet. Im ersten Bereich 1 bleibt die erste Dichte erhalten. Der graduelle Dichteverlauf 22 ist auch als ein Gradient an Dichtewerten 22 bezeichenbar.

Bevorzugt sind die höheren Dichtewerte des graduellen Dichteverlaufs 22 an der Baseplate 9 anordnebar und niedrigere Dichtewerte des graduellen Dichteverlaufs in von der Baseplate entfernten Gegenden angeordnet. Die Baseplate tritt über die Kontaktfläche 99 des Kühlkörpers 10 mit diesem in Kontakt. Der graduelle Dichteverlauf 22 zeichnet sich somit durch eine höhere Wärmeleitung in dichteren Bereichen und dünnere Stege mit wenige Wärmeaufnahme in weniger dichten Bereichen aus.

Der graduelle Dichteverlauf 22 ist herstellbar, indem der Stempel an der Außenfläche (auch als Fläche bezeichenbar) des zweiten Bereichs des Metallschaums angesetzt wird, an welcher die höheren Dichte Werte des graduellen Dichteverlaufs 22 gewünscht sind. Die genannte Außenfläche ist im hergestellten Kühlkörper 10 die Kontaktfläche 99 zur Baseplate 9. Der Stempel wird für das Pressen nur mit einem beschränkten Druck auf die Fläche des Metallschaums gedrückt. So bleibt in vom Stempel und der Fläche weiter entfernten Gegenden des Schaums eine niedrigere Dichte erhalten.

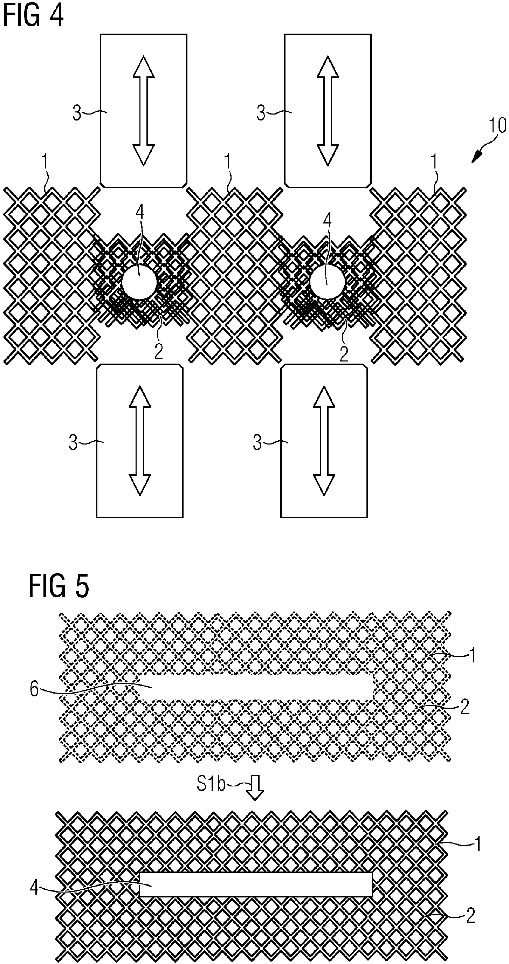

Fig. 3 und Fig. 4 zeigen Weiterbildungen der Erfindung eines gepressten Metallschaum mit einseitigen Verdichtungen (Fig. 3) und zweiseitigen Verdichtungen (Fig. 4) in dem mindestens einem zweiten Bereich 2. Die einseitigen Verdichtungen und die zweiseitigen Verdichtungen werden mit einem Stempel 3 und/oder einer Rolle 3 hergestellt.

Fig. 3 zeigt eine schematische Darstellung eines Kühlkörpers 10 mit zwei einseitigen Verdichtungen des Metallschaums in dem mindestens einem zweiten Bereich 2. Der Kühlkörper 10 ist in Sicht von oben dargestellt. Die einseitige Verdichtung ist durch ein einseitiges Pressen des Metallschaums herstellbar. In dem ersten Bereich 1 bleibt die erste Dichte erhalten.

Fig. 4 zeigt eine schematische Darstellung eines Kühlkörpers mit zweiseitiger Verdichtung in dem mindestens einem zweiten Bereich 2 und einem Vollmaterial 4. Der Kühlkörper 10 ist in Sicht von oben dargestellt. Die zweiseitige Verdichtung ich durch ein zweiseitiges Pressen des Metallschaums herstellbar.

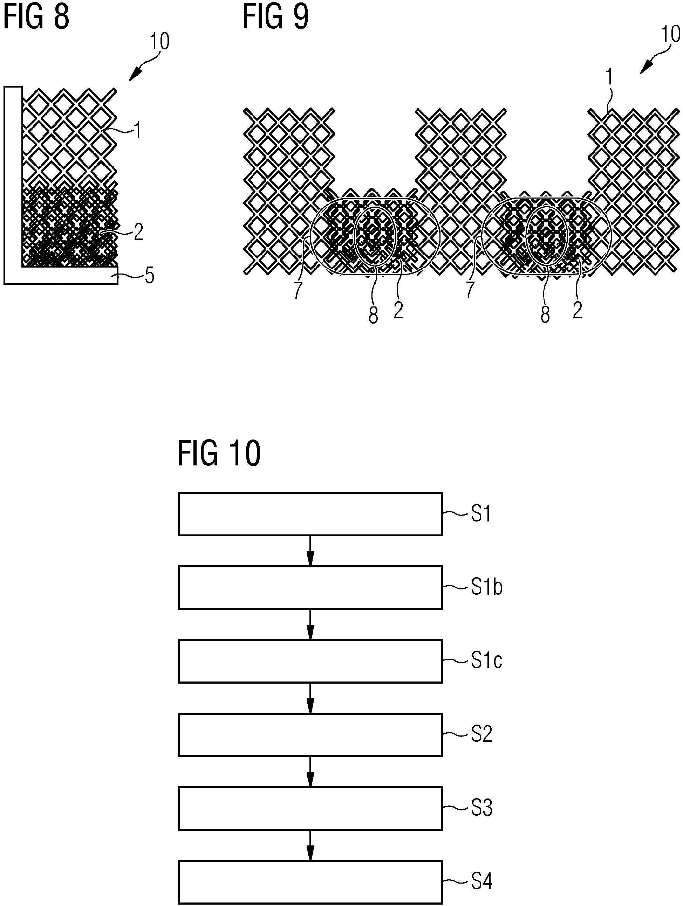

Das Vollmaterial 4 wird in den mindestens einen zweiten Bereich 2 insbesondere vor oder nach dem Verdichten eingeführt, was die Wärmeleitfähigkeit der verdichteten Bereiche 2 weiter erhöht. Im ersten Bereich 1 bleibt die erste Dichte erhalten. Fig. 5 und Fig. 9 zeigen weitere Ausführungsformen mit Vollmaterial 4 und beschreiben mögliche Herstellungsverfahren.

Fig. 5 zeigt eine schematische Darstellung eines Kühlkörpers 10 mit einem Hohlraum 6, insbesondere für ein Vollmaterial 4. Der Kühlkörper 10 ist in Sicht von oben dargestellt.

In dieser Weiterbildung der Erfindung weist der Kühlkörper außerdem auf:
mindestens einen dritten Bereich, wobei der mindestens eine dritte Bereich als ein Hohlraum 6 ausgebildet ist. Dies ist in der oberen schematischen Abbildung der Fig. 5 dargestellt.

Für ein Herstellen des Hohlraums gestaltet sich eine Verarbeitung von Polymerschaum deutlich einfacher als bei dem Metallschaum. Vor einem Galvanikprozess wird insbesondere ein Vollmaterial 4 in den Hohlraum 6 eingelegt (Dies ist in der unteren schematischen Abbildung der Fig. 5 dargestellt), welches durch den Galvanikprozess angebunden wird. Dies entspricht dem Schritt S1b, einem Bereitstellen eines Vollmaterials vor dem ersten Pressen (S2, dargestellt in Fig. 10). Anschließend wird das Polymer ausgebrannt, während das Metall und damit ein Metallschaum bestehen bleibt.

Die Verdichtung in dem mindestens einem zweiten Bereich 2 ist an den unterschiedlichen Produktionsschritten des Schaums herstellbar, insbesondere bereits im Kunststoff-Basisschaum vor dem Galvanikprozess oder in dem finalen Metallschaum nach dem Galvanikprozess. Im ersten Bereich 1 bleibt die erste Dichte erhalten. Das Vollmaterial 4 und/oder der Hohlraum 6 können sowohl an den ersten Bereich 1 als auch an den zweiten Bereich 2 angrenzen. Auch dieser Metallschaum kann nach der Galvanik durch Pressung verdichtet werden.

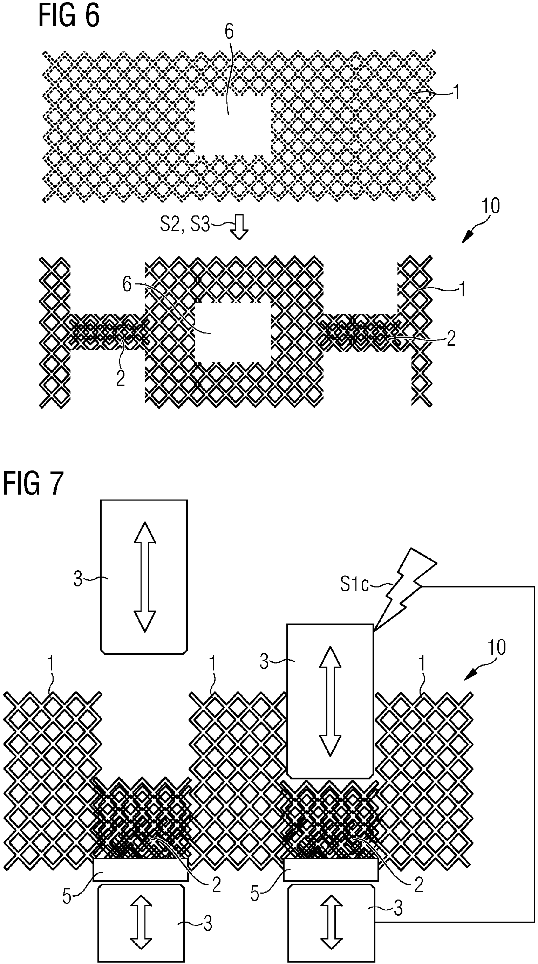

Fig. 6 zeigt eine schematische Darstellung eines Kühlkörpers 10 mit zweiseitiger Verdichtung in dem mindestens einem zweiten Bereich 2 und einem Hohlraum 6, insbesondere für eine Durchströmung. Die zweiseitige Verdichtung wird durch das erste Pressen S2 und das zweite Pressen S3 hergestellt, dargestellt in Fig. 10. Insbesondere ist der Hohlraum 6, auch als eine eingebrachte Öffnung 6 bezeichenbar, auch zur Verbesserung der Durchströmung nutzbar. Der Hohlraum 6 ist auch als Aussparung 6 bezeichenbar. Im ersten Bereich 1 bleibt die erste Dichte erhalten. Der Kühlkörper 10 ist in Sicht von oben dargestellt.

Fig. 7, Fig. 8 und Fig. 9 zeigen weitere Weiterbildung der Erfindung, hier weist der Kühlkörper 10 außerdem auf:
mindestens einen vierten Bereich, wobei der mindestens eine vierte Bereich:
   - ein Vollmaterial 4, 5 (4 nur dargestellt in Fig. 4 und Fig. 5)
   - ein Lotmaterial 7 und/oder
   - ein Metallpulver 8 und/oder
aufweist, wobei der mindestens eine vierte Bereich:
   - von dem mindestens einem zweiten Bereich 2 umschlossen und/oder
   - in Kontakt mit dem mindestens einem zweiten Bereich 2 angeordnet ist.

Im ersten Bereich 1 bleibt die erste Dichte erhalten, in dem zweiten Bereich 2 liegt die zweite Dichte vor.

Fig. 4 zeigt eine Variante, wobei der mindestens eine vierte Bereich von dem mindestens einem zweiten Bereich 2 umschlossen ist. Dies bedeutet, dass der mindestens eine vierte Bereich innerhalb des mindestens einem zweiten Bereichs 2 angeordnet ist.

Fig. 7 zeigt eine schematische Darstellung eines Kühlkörpers 10 mit einseitiger Verdichtung und einem untergelegten Vollmaterial 5, insbesondere einem untergelegten und angeschweißten Metall 5, in Ansicht von oben.

Fig. 8 zeigt eine schematische Darstellung eines Kühlkörpers 10 mit einem untergelegten Vollmaterial 5, insbesondere einem untergelegten und angeschweißten Metall 5, in Seitenansicht.

In Fig. 7 und Fig. 8 ist der mindestens eine vierte Bereich in Kontakt mit dem mindestens einem zweiten Bereich 2 angeordnet und insbesondere durch ein vor dem Verpressen (Schritte S2 und S3 in Fig. 10) durch einen Stempel 3 oder eine Rolle 3 untergelegtes Metall 5 herstellbar, wobei das Metall 5 nach der Verdichtung (Schritte S2 und S3 in Fig. 10), durch Kontaktschweißen S1c, mit dem Schaum verbunden wird. Ein Vorteil dieser Variante ist die direkte Anbindung des Schaums an insbesondere die Baseplate 9, dargestellt in Fig. 1 und Fig. 2. Im ersten Bereich 1 bleibt die erste Dichte erhalten.

Fig. 9 zeigt eine schematische Darstellung und eines Kühlkörpers 10 mit einseitiger Verdichtung, einem Lotmaterial 7 und einem Metallpulver 8. Im ersten Bereich 1 bleibt die erste Dichte erhalten, in dem zweiten Bereich 2 liegt die zweite Dichte vor. Der Kühlkörper 10 ist in Sicht von oben dargestellt.

Eine zusätzliche Erhöhung der Wärmeleitfähigkeit wird durch das Einbringen von dem Lotmaterial 7 erreicht. Kapillarkräfte ziehen flüssiges Lotmaterial/Lot 7 in die Poren des Schaums und dadurch verschließt das Lot offene Bereiche des Schaums, wodurch eine weitere Verdichtung erreicht wird. Zuvor eingebrachtes Metallpulver 8, mit höherer Leitfähigkeit als das Lot 7, erhöht die Wärmeleitfähigkeit zusätzlich. Das Metallpulver 8 wird durch das Lotmaterial 7 fixiert.

Fig. 10 zeigt ein Ablaufdiagramm des erfindungsgemäßen Verfahrens zur Herstellung eines Kühlkörpers. Die Herstellung umfasst die Schritte:
- Schritt S1: Ein Bereitstellen eines Metallschaums, wobei der Metallschaum mindestens einen ersten Bereich 1, aufweisend eine erste Dichte, aufweist und
- Schritt S2: Ein erstens Pressen des Metallschaums an mindestens einem zweiten Bereich 2,
   wodurch der Metallschaum an dem mindestens einem zweiten Bereich 2 mindestens eine zweite Dichte erhält, wobei die mindestens eine zweite Dichte höher als die erste Dichte ist, und
   wodurch der Metallschaum an mindestens einem ersten Bereich 1 die ersten Dichte behält.

Die Herstellung umfasst insbesondere die weiteren Schritte:
- Schritt S3: ein zweites Pressen des mindestens einem zweiten Bereichs 2 von entgegengesetzter Seite des ersten Pressens S2 und/oder
- Schritt S1b: ein Bereitstellen eines Vollmaterials vor dem ersten Pressen S2, wobei das Vollmaterial 4, 5 nach dem ersten Pressen S2 innerhalb des mindestens einem zweiten Bereichs 2 oder in Kontakt mit dem mindestens einem zweiten Bereich 2 angeordnet ist und/oder
- Schritt S4: ein Einbringen eines Lotmaterials 7 in dem mindestens einen zweiten Bereich 2 und/oder
- Schritt S1c: ein Verscheißen des Vollmaterials 5 mit dem mindestens einem zweiten Bereich 2 vor dem ersten Pressen S2.

Obwohl die Erfindung im Detail durch die Ausführungsbeispiele näher illustriert und beschrieben wurde, ist die Erfindung durch die offenbarten Beispiele nicht eingeschränkt und andere Variationen können vom Fachmann daraus abgeleitet werden, ohne den Schutzumfang der Erfindung zu verlassen.

## Patentansprüche

1. Kühlkörper (10) für ein Elektronikbauteil,
aufweisend einen Metallschaum, der Metallschaum aufweisend:
- Mindestens einen ersten Bereich (1), aufweisend eine erste Dichte, und
- mindestens einen zweiten Bereich (2), aufweisend mindestens eine zweite Dichte, wobei die mindestens eine zweite Dichte höher als die erste Dichte ist, wobei der zweite Bereich (2) als gepresster Metallschaum ausgebildet ist.

2. Kühlkörper (10) nach Anspruch 1,
wobei die mindestens eine zweite Dichte als ein gradueller Dichteverlauf (22) ausgebildet ist.

3. Kühlkörper (10) nach einem der vorhergehenden Ansprüche, aufweisend eine Kontaktfläche (99), wobei die Kontaktfläche ausgebildet ist, mit einer Basisplatte (9) des Elektronikbauteils in Kontakt zu treten.

4. Kühlkörper (10) nach Anspruch 3,
wobei der mindestens eine zweite Bereich senkrecht zu der Kontaktfläche (99) angeordnet ist.

5. Kühlkörper (10) nach einem der vorhergehenden Ansprüche, wobei der gepresster Metallschaum:
- eine einseitige Verdichtung oder
- eine zweiseitige Verdichtung
aufweist.

6. Kühlkörper (10) nach einem der vorhergehenden Ansprüche, wobei der mindestens eine erste Bereich ausgebildet ist, von einem Kühlmedium durchströmt zu werden.

7. Kühlkörper (10) nach einem der vorhergehenden Ansprüche, außerdem aufweisend:
mindestens einen dritten Bereich, wobei der mindestens eine dritte Bereich als ein Hohlraum (6) ausgebildet ist.

8. Kühlkörper (10) nach einem der vorhergehenden Ansprüche, außerdem aufweisend:
mindestens einen vierten Bereich, wobei der mindestens eine vierte Bereich:
- ein Vollmaterial (4, 5) und/oder
- ein Lotmaterial (7) und/oder
- ein Metallpulver (8) und/oder
aufweist, wobei der mindestens eine vierte Bereich:
- von dem mindestens einem zweiten Bereich (2) umschlossen und/oder
- in Kontakt mit dem mindestens einem zweiten Bereich (2) angeordnet ist.

9. Kühlkörper (10) nach Anspruch 8,
wobei das Vollmaterial (5) als ein mit dem Metallschaum verschweißtes Metall ausgebildet ist,
wobei das Vollmaterial (5) ausgebildet ist, mit einer Baseplate des Elektronikbauteils in Kontakt zu treten.

10. Kühlkörper (10) nach einem der vorhergehenden Ansprüche, wobei der zweite Bereich (2) ausgebildet ist, Wärme in den Metallschaum aufzunehmen.

11. Herstellung eines Kühlkörpers (10) für ein Elektronikbauteil,
mit den Schritten:
- Ein Bereitstellen eines Metallschaums (S1), wobei der Metallschaum mindestens einen ersten Bereich (1), aufweisend eine erste Dichte, aufweist und
- Ein erstens Pressen (S2) des Metallschaums an mindestens einem zweiten Bereich (2),
wodurch der Metallschaum an dem mindestens einem zweiten Bereich (2) mindestens eine zweite Dichte erhält, wobei die mindestens eine zweite Dichte höher als die erste Dichte ist, und
wodurch der Metallschaum an mindestens einem ersten Bereich (1) die ersten Dichte behält.

12. Herstellung nach Anspruch 11,
wobei für das erste Pressen:
- Ein Stempel (3) und/oder
- eine Rolle (3)
verwendet wird.

13. Herstellung nach Anspruch 11 oder 12,
mit den weiteren Schritten:
- ein zweites Pressen (S3) des mindestens einem zweiten Bereichs (2) von entgegengesetzter Seite des ersten Pressens (S2) und/oder
- ein Bereitstellen eines Vollmaterials (S1b) vor dem ersten Pressen (S2), wobei das Vollmaterial (4, 5) nach dem ersten Pressen (S2) innerhalb des mindestens einem zweiten Bereichs (2) oder in Kontakt mit dem mindestens einem zweiten Bereich (2) angeordnet ist und/oder
- ein Einbringen (S4) eines Lotmaterials (7) in dem mindestens einen zweiten Bereich (2).

14. Herstellung nach Anspruch 13,
mit dem weiteren Schritt:
- ein Verscheißen (S1c) des Vollmaterials (5) mit dem mindestens einem zweiten Bereich (2) vor dem ersten Pressen (S2).

15. Herstellung eines Kühlkörper (10) nach einem der Ansprüche 1 bis 10 durch ein Verfahren nach einem der Ansprüche 11 bis 14.
